# EUROPÄISCHE PATENTANMELDUNG

(11) **EP 4 385 727 A1**
(43) Veröffentlichungstag der Anmeldung: **19.06.2024**
(21) Anmeldenummer: 23215532.5
(22) Anmeldetag: 11.12.2023
(51) Int. Cl.: B32B 15/01, C22C 18/00, C22C 18/04, C22C 21/06, C22C 21/10, C22C 30/06, C22C 38/00, C22C 38/02, C22C 38/04, C22C 38/06, C22C 38/12, C22C 38/14, C22C 38/16, C22C 38/18, C22C 38/38, C23C 2/06, C23C 2/28, C23C 10/28, C23C 14/14, C23C 14/58

(54) **STAHLBLECH MIT OPTIMIERTEM METALLÜBERZUG, VERFAHREN ZUM HERSTELLEN EINES STAHLBLECHS MIT EINEM METALLISCHEN ÜBERZUG**

(30) Priorität: 15.12.2022 DE 102022133485
(71) Anmelder: ThyssenKrupp Steel Europe AG, 47166 Duisburg (DE)
(72) Erfinder: Rogner, Ingo, 85049 Ingolstadt (DE); Schwerdt, Christian, 47058 Duisburg (DE); Strack, Michael, 45665 Recklinghausen (DE)
(74) Vertreter: ThyssenKrupp Steel Europe AG

(57) **Zusammenfassung**

Die Erfindung betrifft ein Stahlblech mit einem Stahlsubstrat (1) und einem auf dem Stahlsubstrat ein- oder beidseitig angeordneten metallischen Überzug (3), welcher als Legierungsschicht ausgeführt ist und eine Kombination aus einer zinkbasierten Schmelztauchbeschichtung und aus einer physikalischen Abscheidung auf Magnesiumbasis umfasst. Des Weiteren betrifft die Erfindung ein Verfahren zum Herstellen eines entsprechenden Stahlblechs sowie eine Verwendung.

## Beschreibung

Die Erfindung betrifft ein Stahlblech mit einem Stahlsubstrat und einem auf dem Stahlsubstrat ein- oder beidseitig angeordneten metallischen Überzug, welcher als Legierungsschicht ausgeführt ist und eine Kombination aus einer zinkbasierten Schmelztauchbeschichtung und aus einer physikalischen Abscheidung auf Magnesiumbasis umfasst. Des Weiteren betrifft die Erfindung ein Verfahren zum Herstellen eines entsprechenden Stahlblechs sowie eine Verwendung.

Im industriellen Sektor und somit im Non-Auto-Bereich ist derzeit der Trend, Stahlbleche mit einer Feuerbeschichtung auf Zink-Magnesiumbasis mit einer guten Korrosionsbeständigkeit zu verwenden, beispielsweise zur Herstellung von Unterkonstruktionen bei Photovoltaikanlagen.

Des Weiteren sind aus dem Stand der Technik auch Verfahren zum Herstellen von Stahlblechen mit aus Schmelztauchveredelung und physikalischer Abscheidung kombinierten umfassenden Metallüberzügen bekannt, vgl. beispielsweise DE 10 2005 045 780 A1, DE 195 27 515 C1 und CN 105 177 573 A.

Die DE 10 2005 045 780 A1 und CN 105 177 573 A offenbaren gattungsgemäße Verfahren sowie gattungsgemäße Stahlbleche mit einem Stahlsubstrat, auf welches eine erste Beschichtung aus einer Zinkschmelze und anschließend eine zweite Beschichtung aus einer physikalischen Abscheidung mit Magnesium appliziert wird, wobei nach der Beschichtung eine Wärmebehandlung durchgeführt wird, so dass eine Legierungsschicht als Metallüberzug auf dem Stahlsubstrat gebildet wird.

Die Aufgabe ist daher, einen verbesserten Korrosionsschutz bereitzustellen.

Die Aufgabe wird gelöst mit Bezug auf ein Stahlblech mit einem Stahlsubstrat und einem auf dem Stahlsubstrat ein- oder beidseitig angeordneten metallischen Überzug, welcher als Legierungsschicht ausgeführt ist und eine Kombination aus einer zinkbasierten Schmelztauchbeschichtung und aus einer physikalischen Abscheidung auf Magnesiumbasis umfasst, **dadurch gekennzeichnet, dass** der Überzug einen Aluminiumgehalt von mindestens 0,15 Gew.-% aufweist.,

Weiterhin wird die Aufgabe gelöst mit Bezug auf ein Verfahren zum Herstellen eines Stahlblechs mit einem metallischen Überzug, umfassend folgende Schritte:
- Bereitstellen eines Stahlsubstrats,
- ein- oder beidseitiges Schmelztauchbeschichten auf Zinkbasis des Stahlsubstrats,
- Aufbringen einer weiteren Beschichtung auf der schmelztauchbeschichteten Seite durch physikalische Abscheidung auf Magnesiumbasis,
- Wärmebehandlung zur Ausbildung einer Legierungsschicht,
**dadurch gekennzeichnet, dass** der zinkbasierten Schmelze Aluminium mit einem Gehalt von mindestens 0,15 Gew.-% zulegiert wird.

Außerdem wird die Aufgabe gelöst mit Bezug auf eine Verwendung eines entsprechenden Stahlblechs, insbesondere hergestellt gemäß dem beschriebenen Verfahren, für Teile im Maschinen-, Stahl- oder Anlagenbau..

Insbesondere wird die Aufgabe auch gelöst durch ein Stahlblech mit einem Stahlsubstrat und einem auf dem Stahlsubstrat ein- oder beidseitig angeordneten metallischen Überzug, welcher als Legierungsschicht ausgeführt ist und aus den folgenden Elementen besteht:
- Aluminium 0,15 bis 58 Gew.-%
- Magnesium 3 bis 25 Gew.-%
- Silizium bis 3 Gew.-%
- Rest Zink und unvermeidbare Verunreinigungen,
wobei der Magnesiumgehalt ausgehend von der freien Oberfläche des Überzugs in Richtung des Stahlsubstrats abnimmt. Ein solcher Überzug kann hergestellt werden durch ein- oder beidseitiges Schmelztauchbeschichten des bereitgestellten Stahlsubstrates mit einer Schmelztauchbeschichtung auf Zinkbasis, nachfolgendes Aufbringen einer weiteren Beschichtung auf den schmelztauchbeschichteten Seiten durch physikalische Abscheidung auf Magnesiumbasis und anschließende Wärmebehandlung zur Ausbildung einer Legierungsschicht.

Die Erfinder haben festgestellt, dass bei Vorhandensein von Aluminium im Überzug, d. h. in der Legierungsschicht, mit einem Mindestgehalt von 0,15 Gew.-%, insbesondere von 0,25 Gew.-%, vorzugsweise von 0,50 Gew.-%, insbesondere von 1,10 Gew.-%, bevorzugt von 1,15 Gew.-%, besonders bevorzugt von 3,0 Gew.-%, weiter bevorzugt von 4,0 Gew.-% ein besseres Korrosionsverhalten erzielt werden kann, da die Korrosion langsamer voranschreiten kann, bzw. eine gute Haftung zwischen Substrat und Überzug bedingt durch eine Grenzschichtausbildung und dadurch insbesondere eine Eisendiffusion in den Überzug verhindert werden kann. Auf diese Weise sorgt der erfindungsgemäße Aluminiumgehalt dafür, dass zwar einerseits während der Wärmebehandlung der Gradient im Magnesiumgehalt einstellen kann, aber andererseits die Diffusion von Eisen aus dem Stahlsubstrat unterdrückt wird.

Bei einigen Ausführungsformen ist der Aluminiumgehalt auf maximal 58%, bevorzugt maximal 8%, insbesondere maximal 5%, weiterhin bevorzugt maximal 3,0%, vorzugsweise maximal 2,0% insbesondere maximal 1,5%, vorzugsweise maximal 1,4% begrenzt.

Die Kombination der unterschiedlichen Beschichtungen erfordert nach der physikalischen Abscheidung eine Wärmebehandlung, welche zu einer Legierungsschicht und somit zu einer im Wesentlichen Vermischung der Beschichtungsschichten bzw. zu einem Durchlegieren der Schichten führt. Die Art der Wärmebehandlung und somit die Durchführung ist bekannt, vgl. auch DE 195 27 515 C1.

Der Aluminiumgehalt im Überzug respektive in der Legierungsschicht stammt aus der zinkbasierten Schmelztauchbeschichtung, da eine Applikation aus der physikalischen Abscheidung, vorzugsweise in einem PVD-Prozess, sehr aufwendig ist bedingt durch den Schmelzpunkt aber auch durch den Siedepunkt des Aluminiums, welcher im Vergleich zu Magnesium und optional Zink viel höher ist. Zudem ist Aluminium bei derartigen Applikationen als hoch korrosiv bekannt. Außerdem sollte sich Aluminium bevorzugt substratnah befinden, damit die Diffusion von Eisen aus dem Stahlsubstrat unterdrückt werden kann.

Gemäß einer Ausgestaltung weist der Überzug respektive die Legierungsschicht einen Magnesiumgehalt von mindestens 3 Gew.-%. Der Gehalt von mindestens 3 Gew.-% bezieht sich im Mittel über die gesamte Dicke des Überzugs betrachtet. Der Magnesiumgehalt stammt zumindest aus der physikalischen Abscheidung. Die zinkbasierte Schmelztauchbeschichtung kann Magnesium enthalten, so dass dann über die Schmelztauchbeschichtung der Gehalt des Magnesiums sich innerhalb des Überzugs respektive in der Legierungsschicht zusätzlich zum Gehalt des Magnesiums, welcher über die physikalische Abscheidung eingebracht wird, und letztendlich über eine Wärmebehandlung des kombinierten Schichtaufbaus einstellt bzw. ergibt.

Der Gehalt an Magnesium im Überzug beträgt also mindestens 3 Gew.-%, bevorzugt mindestens 4 Gew.-%, insbesondere mindestens 5 Gew.-%. Der Maximalgehalt an Magnesium beträgt 25 Gew.-%, vorzugsweise 20 Gew.-%, insbesondere 15 Gew.-%, bevorzugt 10 Gew.-%, insbesondere 8 Gew.-%, vorzugsweise 7 Gew.-%, insbesondere 6 Gew.-%.

Der Gehalt an Silizium im Überzug kann Null betragen, d.h. Silizium ist nur als unvermeidbare Verunreinigung enthalten. Alternativ kann der Gehalt an Silizium auch mindestens 0,20 Gew.-%, vorzugsweise mindestens 0,50 Gew.-% betragen. Der Maximalgehalt an Silizium beträgt 3 Gew.-%, vorzugsweise 2,5 Gew.-%, insbesondere 2,20 Gew.-%.

Bei einer besonders bevorzugten Ausführungsform besteht der metallische Überzug, welcher als Legierungsschicht ausgeführt ist, aus den folgenden Elementen:
- Aluminium 0,15 bis 1,5 Gew.-%
- Magnesium 3 bis 10 Gew.-%
- Silizium bis 3 Gew.-%
- Rest Zink und unvermeidbare Verunreinigungen.

Die Wärmebehandlung kann sich gezielt zwischen Liquidus- und Solidustemperatur der insbesondere abgeschiedenen Schicht bewegen, oder auch unterhalb der Solidustemperatur eine reine Festkörperinterdiffusion anstreben. Dies ermöglicht die gezielte Beeinflussung der Schichtstruktur (Legierungsstruktur) bei gleicher chemischer Zusammensetzung und damit eine flexible Anpassung an den vorgesehenen Anwendungsfall. Eine Wärmebehandlung unterhalb der Liquidustemperatur hat den Vorteil, dass Bereiche primärer Zinkkristalle erhalten bleiben und die sich nach der Abkühlung ergebende Mikrostruktur deutliche Ähnlichkeit mit der Mikrostruktur klassischer (d.h. schmelztauchbeschichteter) ZM-Überzüge aufweist, so dass deren Vorteile erhalten bleiben. Noch deutlicher ist dieser Effekt unterhalb der Solidustemperatur, unterhalb derer eine reine Festkörperdiffusion stattfindet. Bei der Festkörperdiffusion diffundiert typischerweise Zink in die Deckschicht, die durch physikalische Abscheidung auf Magnesiumbasis gebildet ist. Es bildet sich eine Übergangszone mit MgZn₂, deren Dicke von der Dauer der Wärmebehandlung und dem vorhandenen Verhältnis von Mg zu Zn im Überzug abhängig ist.

Da die Kombination aus einer zinkbasierten Schmelztauchbeschichtung mit einem geringen bis keinen Gehalt an Magnesium und aus einer physikalischen Abscheidung auf Magnesiumbasis mit einem hohen Anteil an Magnesium auf dem Stahlsubstrat als metallischer Überzug respektive, bedingt durch eine Wärmebehandlung, als eine Legierungsschicht ein- oder beidseitig angeordnet ist, kann der Magnesiumgehalt ausgehend von der freien Oberfläche des Überzugs in Richtung des Stahlsubstrats abnehmen.

Dieser gesamte Aufbau des Überzugs hat verschiedene Vorteile. Die Fe-Al-Diffusionsschicht an der Grenze zum Substrat sorgt dafür, dass der Überzug sich fest mit dem Substrat verbindet und damit gegen Abplatzungen gesichert ist. Der ansteigende Magnesiumgehalt zur Oberfläche (bzw. der von der freien Oberfläche zum Stahlsubstrat hin abnehmende Magnesiumgehalt) führt zu einer hohen Oberflächenhärte des Überzugs. Hierdurch ergibt sich eine Abriebverbesserung bei der Verarbeitung in Umformwerkzeugen wie z. Rollprofilen. Ein Abrieb ist bei einer derartigen Verarbeitung nachteilig, weil sich der Abrieb auf Werkzeugoberflächen absetzt und somit den Reinigungsaufwand erhöht.

Bei einer bevorzugten Ausführungsform weist die freie Oberfläche des Überzuges eine Vickershärte von mindestens 130 HV0,1, bevorzugt mindestens 160 HV0,1, insbesondere mindestens 200 HV0,1 auf. Die Messung der Vickershärte erfolgt gemäß ISO 6507.

Dabei kann gemäß einer Ausgestaltung die Dicke des Überzugs respektive die Legierungsschicht zwischen 20 und 100 µm pro Seite betragen. Insbesondere kann die Dicke mindestens 25 µm, vorzugsweise mindestens 30 µm und insbesondere höchstens 90 µm, vorzugsweise höchstens 80 µm pro Seite betragen.

Eine Legierung des Stahlsubstrats enthält oder besteht aus den folgenden Elementen in Gew.-%:

| | |
|---|---|
| C: | 0,050 bis 0,250%, insbesondere 0,060 bis 0,250%, vorzugsweise 0,070 bis 0,250%; |
| Si: | 0,0010 bis 0,70%, insbesondere 0,0010 bis 0,40%, vorzugsweise 0,0010 bis 0,30%; |
| Mn: | 0,010 bis 1,70%, insbesondere 0,010 bis 1,60%, vorzugsweise 0,010 bis 1,40%; |
| P: | bis 0,10%, insbesondere bis 0,080%, vorzugsweise bis 0,060%; |
| S: | bis 0,050%, insbesondere bis 0,040%, vorzugsweise bis 0,030%; |
| N: | bis 0,10%, insbesondere bis 0,050%, vorzugsweise bis 0,030%; |
| Al: | 0,010 bis 0,150%, insbesondere 0,010 bis 0,10%, vorzugsweise 0,010 bis 0,090%; |

optional eines oder mehrere der folgenden Elemente:
Cu bis 0,80% und/oder Cr bis 0,70% und/oder Nb bis 0,10% und/oder Ti bis 0,20%;
Rest Eisen und erschmelzungsbedingte Verunreinigungen.

Das Substrat kann vorzugsweise ein warmgewalztes Stahlflachprodukt (Warmband), beispielsweise mit einer Dicke zwischen 1,80 und 6,0 mm, oder ein kaltgewalztes Stahlflachprodukt (Kaltband) sein, beispielsweise mit einer Dicke zwischen 0,7 und 2,5 mm.

Gemäß einer Ausgestaltung weist die freie Oberfläche des Überzugs respektive der Legierungsschicht, insbesondere nach einem optionalen Dressieren bzw. Dressierschritt, einen normierten Magnesiumanteil von mindestens 65 % auf, wobei die Summe der normierten Anteile von Magnesium und mindestens eines weiteren Elements aus der Gruppe (Aluminium, Zink, Silizium) 100 % beträgt, wobei mittels ToF-SIMS Rohsignal-Integrale der vorhandenen Elemente gemessen werden und der normierte Mg-Anteil aus dem Quotienten Mg-Rohsignal-Integral / Summe der vorhandenen Elemente-Rohsignal-Integrale bestimmt wird. Der Magnesiumanteil kann insbesondere mindestens 70 %, vorzugsweise mindestens 75 %, bevorzugt mindestens 80 % betragen. Entfällt der optionale Dressierschritt, können tendenziell höhere Magnesiumanteile gemessen werden. Die Angabe des normierten Anteils entspricht insbesondere dem ermittelten Mittelwert, wobei Schwankungen im Rahmen von Messtoleranzen (Standardabweichung) vorliegen können. Ein Magnesiumanteil von 100 % ist praktisch nicht möglich, daher ist dieser kleiner 100 %. Die Summe der normierten Anteile von Magnesium sowie weiterer Elemente, die sowohl als Bestandteil in der Schmelztauchbeschichtung wie auch in der physikalisch abgeschiedenen Schicht vorhanden sind, insbesondere aus der Gruppe (Aluminium, Zink, Silizium) beträgt immer 100 %.

Die Bestimmung der relativen Konzentration von Silizium, Zink, Magnesium und Aluminium erfolgt durch Bestimmung der absoluten Konzentration dieser Elemente und anschließende Normierung auf 100 %. Dabei wird die Summe der Konzentration an Silizium, Zink, Magnesium und Aluminium gleich 100 gesetzt und der Anteil des jeweiligen Elements an diesem 100 % als relative Konzentration, also bezogen auf 100 %, gewertet bzw. gewichtet. Die relative Konzentration eines Elements (Si, Al, Mg, Zn) bezieht sich mithin auf die Summe der Konzentrationen der Elemente Si, Mg, Zn und Al, indem diese Summe 100 % darstellt. Da die absolute Konzentration der Elemente Si, Zn, Mg und AI von Überzug zu Überzug variieren kann, erfolgt die Angabe als relative Konzentration in Prozentpunkten, um Änderungen genau zu definieren. Dabei wird das Vorkommen der Elemente Silizium, Zink, Magnesium und Aluminium im Sinne der Erfindung unabhängig von der Form erfasst, in welcher diese vorliegen. Es spielt mithin keine Rolle, ob diese Elemente als neutrale Atome oder als Ionen, in einem Verbund, wie zum Beispiel Legierung oder intermetallische Phasen oder in einer Verbindung wie zum Beispiel Komplexe, Oxide, Salze, Hydroxide oder Ähnliches, vorliegen. Somit können die Begriffe "Silizium", "Zink", "Aluminium" und "Magnesium" im Sinne der Erfindung nicht nur die Elemente in reiner Form, sondern zusätzlich oxidische und/oder hydroxidische bzw. jegliche Form von Verbindungen, die diese Elemente enthalten, erfassen.

Ermittelt werden können die relativen Konzentrationsunterschiede bezüglich Silizium, Magnesium, Aluminium und Zink an der Oberfläche des Überzugs respektive der Legierungsschicht durch Aufnahme der örtlichen Verteilung der Signale für diese Elemente mittels Flugzeit-Sekundärionen-Massenspektrometer (**T**ime-**o**f-**F**light **S**econdary **I**on **M**ass **S**pectrometry, ToF-SIMS) im abbildenden Modus oder in ähnlicher Weise mittels Augerelektronen- oder Photoelektronenspektroskopie. Die ToF-SIMS stellt ein Analyseverfahren zur Bestimmung der chemischen Oberflächenzusammensetzung der obersten 1-3 Monolagen dar. Mittels ToF-SIMS werden bestimmte relative Konzentrationsunterschiede gemessen, in dem die zu analysierende Oberfläche innerhalb einer repräsentativen Messfläche rasternd untersucht wird. Dabei wird an jeder Position des Rasters ein Spektrum in der positiven Polarität aufgenommen und die Rohsignale für die Hauptbestandteile (Legierungselemente) aufgenommen. Die relative Konzentration des Elements X, welches in diesem Fall für eines der im schmelztauchveredelten und dressierten Überzug befindlichen Legierungselemente steht, ergibt sich aus dem Quotienten [X-Rohsignal-Integral / (Si-Rohsignal-Integral + Zn-Rohsignal-Integral + Mg-Rohsignal-Integral + AI-Rohsignal-Integral)], wobei im Nenner des Quotienten die Summe der Rohsignal-Integrale aller im Überzug befindlichen Legierungselemente steht. "Rohsignal" des Elementes X bei dieser Definition ist die Intensität bzw. Peak-Fläche des Elementes X im Massenspektrum bzw. "Rohsignal-Integral" des Elementes X ist die integrierte Intensität, welche über eine definierte zusammenhänge Fläche von Rasterpositionen dargestellt und dem jeweiligen Element X zugeordnet wird. Die internen ToF-SIMS-Messungen wurden mittels eines Geräts TOF.SIMS 5, der Firma ION-TOF GmbH durchgeführt.

Gemäß einem zweiten Aspekt betrifft die Erfindung ein Verfahren zum Herstellen eines Stahlblechs mit einem Metallüberzug, umfassend folgende Schritte:
- Bereitstellen eines Stahlsubstrats,
- ein- oder beidseitiges Schmelztauchbeschichten auf Zinkbasis des Stahlsubstrats,
- Aufbringen einer weiteren Beschichtung auf der schmelztauchbeschichteten Seite durch physikalische Abscheidung auf Magnesiumbasis,
- Wärmebehandlung zur Ausbildung einer Legierungsschicht, wobei der zinkbasierten Schmelze Aluminium mit einem Gehalt von mindestens 0,15 Gew.-% zulegiert wird.

Um Wiederholungen zu vermeiden, wird auf das Vorgenannte verwiesen.

Die Schmelze bzw. die daraus ein- oder beidseitig schmelztauchbeschichtete Schicht enthält oder besteht aus den folgenden Elementen in Gew.-%:
- Aluminium: 0,15 bis 58 %, bevorzugt mindestens 0,25%, insbesondere mindestens 0,50%, insbesondere mindestens 1,10%, vorzugsweise mindestens 1,15%; insbesondere mindestens 1,2%, besonders bevorzugt mindestens 1,3%, weiterhin bevorzugt maximal 8%, insbesondere maximal 5%, weiterhin bevorzugt maximal 3,0%, vorzugsweise maximal 2,0% insbesondere maximal 1,5%, vorzugsweise maximal 1,4%.
- Magnesium: (0) bis 8 %, insbesondere mindestens 0,50%, vorzugsweise mindestens 1,10%, weiterhin bevorzugt maximal 6%, insbesondere maximal 4%, vorzugsweise maximal 3%, insbesondere maximal 2,0%, bevorzugt maximal 1,5%;
- Silizium: (0) bis 3 %, insbesondere 0,20 bis 2,5 %, vorzugsweise 0,50 bis 2,20 %;
- Rest Zink und unvermeidbare Verunreinigungen, wobei insbesondere als Verunreinigung mindestens eines der Elemente aus der Gruppe (Cr, Ti, Ni, Pb, Zr, Mn, Ca, La, Cer, Sb, Sn) enthalten sein kann und in Summe bis zu maximal 0,50 Gew.-%, insbesondere bis zu maximal 0,30 Gew.-%, vorzugsweise bis zu maximal 0,20 Gew.-% betragen kann.

In einer ersten Variante kann die Schmelze bzw. die daraus ein- oder beidseitig schmelztauchbeschichtete Schicht folgende Elemente in Gew.-% enthalten oder daraus bestehen: Aluminium: 3 bis 8 %, bevorzugt 4 bis 6%, Rest Zink und unvermeidbare Verunreinigungen. Somit kann beispielhaft eine Schicht, bekannt als Galfan oder ZA, mit ca. 5 % AI und 95 % Zn ein- oder beidseitig aufgebracht werden.

In einer zweiten Variante kann die Schmelze bzw. die daraus ein- oder beidseitig schmelztauchbeschichtete Schicht folgende Elemente in Gew.-% enthalten oder daraus bestehen: Aluminium: 50 bis 58 %, Silizium: 1,0 bis 2,5 %, Rest Zink und unvermeidbare Verunreinigungen. Somit kann beispielhaft eine Schicht, bekannt als Galvalume oder AZ, mit ca. 55 % Al, 1,6 % Si und 43,4 % Zn ein- oder beidseitig aufgebracht werden.

In einer dritten Variante kann die Schmelze bzw. die daraus ein- oder beidseitig schmelztauchbeschichtete Schicht folgenden Elementen in Gew.-% enthalten oder daraus bestehen: Aluminium: 1,1 bis 5 %, insbesondere 1,2 bis 3,0%, bevorzugt 1,3 bis 2,0%, Magnesium: 1,1 bis 5 %, insbesondere 1,2 bis 3,0%, bevorzugt 1,3 bis 2,0%, Rest Zink und unvermeidbare Verunreinigungen. Somit kann beispielhaft eine Schicht, bekannt als ZM oder ZAM, mit ca. 3 % Al, 3 % Mg und 94 % Zn ein- oder beidseitig aufgebracht werden.

In einer vierten Variante kann die Schmelze bzw. die daraus ein- oder beidseitig schmelztauchbeschichtete Schicht (d.h. die zinkbasierte Schmelztauchbeschichtung) folgende Elemente in Gew.-% enthalten oder daraus bestehen: Aluminium: bis zu 0,3%, vorzugsweise mindestens 0,15%, Rest Zink und unvermeidbare Verunreinigungen.

Beim Schmelztauchbeschichten mit Al-haltigen Zinkschmelzen bildet sich während des Abkühlprozesses eine Al-haltige Oxidschicht an der Oberfläche aus. Bei zusätzlicher Zugabe von Mg zur Schmelze entsteht beim Abkühlprozess ein geschichteter Aufbau der Oxidschicht aus einer geschlossenen Mg-Oxidschicht und darunter befindlichen Al-Oxiden. Aufgrund des höheren Dipolmoments entsprechend der Elektronegativitätsdifferenz von Mg-Oxid (ΔEN=2,27) gegenüber Al-Oxid (ΔEN=2,03) oder Zink-Oxid (ΔEN=1,84), werden auf die Mg-Oxidschicht aufgebrachte polarisierbare oder dipolare Verbindungen stärker an die Oberfläche gebunden. Um nachteilige Einflüsse hinsichtlich der Oxide insbesondere bei magnesiumhaltigen Zinkschmelzen zu vermeiden, kann ein Behandlungsschritt vor dem physikalischen Abscheiden durchgeführt werden, indem eine Entfernung der Oxide an der Oberfläche durch Dekapieren, beispielsweise mit einer Säure, wobei diese Vorgehensweise der Fachwelt bekannt ist, und/oder mittels einer Plasmafeinreinigung, vgl. auch CN 105 177 573 A und somit auch der Fachwelt bekannt ist, durchgeführt wird.

"Zinkbasiert" bedeutet im Sinne der Erfindung, dass mindestens 40 Gew.-% Zink in der Schmelze bzw. in der Schmelztauchbeschichtung enthalten sein muss.

Optional kann das mit einem ein- oder beidseitig durch Schmelztauchen beschichteten Stahlsubstrat vor dem physikalischen Abscheiden und nach oder vor dem optionalen Behandlungsschritt zur Entfernung der Oxide mit einer Oberflächenstruktur dressiert werden. Dabei kommen Dressierwalzen zum Einsatz, welche eine stochastische oder deterministische Oberflächentextur aufweisen, welche sich abhängig von der Rauheit und/oder vom Dressiergrad und somit von der Dressierkraft und der optionalen Reckkraft in die Oberfläche der Schmelztauchbeschichtung einprägt.

Das physikalische Abscheiden erfolgt vorzugsweise durch einen PVD-Prozess, bevorzugt durch Spritzapplikation im Vakuum. Verfahren und Vorrichtungen zur Umsetzung sind Stand der Technik, vgl. beispielsweise WO 2016/042079 A1.

Das physikalische Abscheiden kann in einer Schicht oder zwei Schichten erfolgen, was bedeutet, dass entweder nur Magnesium in einer Schicht aufgebracht bzw. aufgedampft wird oder eine Schicht Magnesium und eine weitere Schicht, vorzugsweise Zink, nacheinander aufgebracht bzw. aufgedampft werden. Die eine Schicht kann auch beispielsweise zwei Metalle enthalten oder bestehen aus Magnesium und einem weiteren Element, vorzugsweise Zink, in situ aufgebracht bzw. aufgedampft werden. Bevorzugt wird das physikalische Abscheiden aber in einem Schritt durchgeführt. Die Schicht, welche das Magnesium enthält, wird somit durchmischt mit dem zweiten Element, bevorzugt Zink, gleichzeitig abgeschieden. Das zugrundeliegende Verfahren kann dazu frei nach dem Stand der Technik gewählt werden.

"Magnesiumbasis" bedeutet im Sinne der Erfindung, dass mindestens 50 Gew.-% Magnesium in der zumindest eine applizierte Schicht enthalten sein muss.

Gemäß einer Ausgestaltung werden die Schritte der Schmelztauchbeschichtung und der physikalischen Abscheidung diskontinuierlich in separaten Anlagen durchgeführt. Dies ermöglicht u.a. eine zeitliche Entkopplung der beiden Beschichtungsverfahren und somit auch eine von der Prozessgeschwindigkeit unabhängige Applikation der unterschiedlichen Beschichtungsschichten. Anlagen zur Durchführung der physikalischen Abscheidung sind der Fachwelt bekannt, vgl. u.a. DE 10 2020 121 923 A1.

Gemäß einer alternativen Ausgestaltung kann der Schritt der physikalischen Abscheidung kontinuierlich im Anschluss an die Schmelztauchbeschichtung erfolgen. Hier besteht der Vorteil u.a. darin, dass ein entsprechendes Modul zur physikalischen Abscheidung in eine bestehende Schmelztauchbeschichtungsanlage respektive -linie integriert wird. In vorteilhafterweise kann das Modul oberhalb bzw. in Prozessrichtung betrachtet hinter den Abstreifdüsen, über welche die Schmelztauchbeschichtungsdicke eingestellt wird, angeordnet sein, wobei die Abstreifdüsen eingehaust sind, um insbesondere ein Vakuum sicherstellen zu können, so dass die Einhausung mit einer Öffnung in die Schmelze hineinragt, welche als einlaufseitige Vakuumdichtung fungiert. Auf der Auslaufseite kann beispielsweise eine Wasserschleuse vorgesehen sein, vgl. beispielhaft DE 10 2017 223 778 B4, wobei alternativ auf der Einlaufseite eine Wasserschleuse vorgesehen sein kann. Zur Aufrechterhaltung eines Vakuums in dem Abschnitt (Modul), in welchem eine physikalische Abscheidung umgesetzt wird, werden vorzugsweise Wälzkolbenpumpen, vgl. beispielhaft DE 10 2017 221 346 A1, eingesetzt. Eine entsprechende Inline-Auslegung ist damit der Fachwelt bekannt.

Gemäß einer Ausgestaltung kann ein Dressierschritt nach der Schmelztauchbeschichtung und vor dem physikalischen Abscheiden durchgeführt werden.

Gemäß einer Ausgestaltung kann ein Dressierschritt nach dem physikalischen Abscheiden und der Wärmebehandlung durchgeführt werden.

Die Art und Weise des Dressierens ist dem Fachmann geläufig und kann individuell auf den Anwendungsfall angepasst werden.

Gemäß einer Ausgestaltung kann nach dem physikalischen Abscheiden und der Wärmebehandlung und optionalen Dressierschritt eine Konversionsschicht, Passivierung oder Beölung appliziert werden. Die Art und Weise der Konversion, Passivierung oder Beölung sind dem Fachmann geläufig.

Gemäß eines dritten Aspekts betrifft die Erfindung eine Verwendung eines erfindungsgemäßen Stahlblechs, welches für Teile im Maschinen-, Stahl- oder Anlagenbau insbesondere nach dem erfindungsgemäßen Verfahren hergestellt worden ist.

Besondere Ausgestaltungen finden sich in den folgenden Sätzen:
1. Stahlblech mit einem Stahlsubstrat und einem auf dem Stahlsubstrat (1) ein- oder beidseitig angeordneten metallischen Überzug (3), welcher als Legierungsschicht ausgeführt ist und eine Kombination aus einer zinkbasierten Schmelztauchbeschichtung und aus einer physikalischen Abscheidung auf Magnesiumbasis umfasst, **dadurch gekennzeichnet, dass** der Überzug (3) einen Aluminiumgehalt von mindestens 0,15 Gew.-% aufweist.
2. Stahlblech nach Satz 1, wobei der Überzug (3) einen Magnesiumgehalt von mindestens 3 Gew.-% aufweist.
3. Stahlblech nach einem der vorgenannten Sätze, wobei der Magnesiumgehalt ausgehend von der freien Oberfläche des Überzugs (3) in Richtung des Stahlsubstrats (1) abnimmt.
4. Stahlblech nach einem der vorgenannten Sätze, wobei der Überzug (3) eine Dicke von 20 bis 100 µm pro Seite aufweist.
5. Stahlblech nach einem der vorgenannten Sätze, wobei das Stahlsubstrat (1) eine Legierung enthält oder besteht aus den folgenden Elementen in Gew.-%:

| | |
|---|---|
| C: | 0,050 bis 0,250 %; |
| Si: | 0,0010 bis 0,70 %; |
| Mn: | 0,010 bis 1,70 %; |
| P: | bis 0,10 %; |
| S: | bis 0,050 %; |
| N: | bis 0,10 %; |
| Al: | 0,010 bis 0,150 %; |

optional eines oder mehrere folgender Elemente:
Cu bis 0,80 % und/oder
Cr bis 0,70 % und/oder
Nb bis 0,10 % und/oder
Ti bis 0,20 %;
Rest Eisen und erschmelzungsbedingte Verunreinigungen.
6. Stahlblech nach einem der vorhergehenden Sätze, wobei die freie Oberfläche des Überzugs (3) einen normierten Magnesiumanteil von mindestens 65 % aufweist, wobei die Summe der normierten Anteile von Magnesium und mindestens eines weiteren Elements aus der Gruppe (Aluminium, Zink, Silizium) 100 % beträgt, wobei mittels ToF-SIMS Rohsignale-Integrale der vorhandenen Elemente gemessen werden und der normierte Mg-Anteil aus dem Quotienten Mg-Rohsignal-Integral / Summe der vorhandenen Elemente-Rohsignal-Integrale bestimmt wird.
7. Verfahren zum Herstellen eines Stahlblechs mit einem metallischen Überzug (3), umfassend folgende Schritte:
- Bereitstellen eines Stahlsubstrats (1),
- ein- oder beidseitiges Schmelztauchbeschichten (2) auf Zinkbasis des Stahlsubstrats (1),
- Aufbringen einer weiteren Beschichtung auf der schmelztauchbeschichteten Seite durch physikalische Abscheidung auf Magnesiumbasis,
- Wärmebehandlung zur Ausbildung einer Legierungsschicht (3),
**dadurch gekennzeichnet, dass** der zinkbasierten Schmelze Aluminium mit einem Gehalt von mindestens 0,15 Gew.-% zulegiert wird.
8. Verfahren nach Satz 7, wobei die Schritte der Schmelztauchbeschichtung und der physikalischen Abscheidung diskontinuierlich in separaten Anlagen durchgeführt werden.
9. Verfahren nach Satz 7, wobei der Schritt der physikalischen Abscheidung kontinuierlich im Anschluss an die Schmelztauchbeschichtung durchgeführt wird.
10. Verfahren nach einem der Sätze 7 bis 9, wobei ein Dressierschritt nach der Schmelztauchbeschichtung und vor dem physikalischen Abscheiden durchgeführt wird.
11. Verfahren nach einem der Sätze 7 bis 10, wobei ein Dressierschritt nach dem physikalischen Abscheiden und der Wärmebehandlung durchgeführt wird.
12.Verfahren nach einem der Sätze 7 bis 11, wobei nach dem physikalischen Abscheiden und der Wärmebehandlung und optionalen Dressierschritt eine Konversionsschicht, Passivierung oder Beölung appliziert wird.
13.Verwendung eines Stahlblechs nach einem der Sätze 1 bis 6, insbesondere hergestellt nach einem der Sätze 7 bis 12, für Teile im Maschinen-, Stahl- oder Anlagenbau.

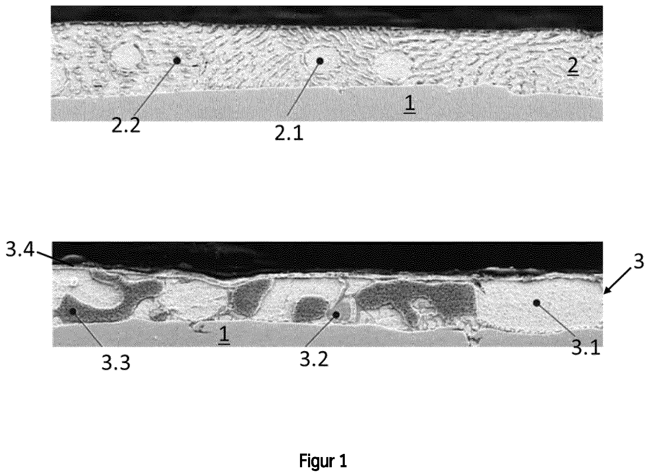

Ein warmgewalztes Stahlsubstrat der Güte S235 mit einer Dicke von 4,0 mm wurde mit einer ZA-Schmelztauchbeschichtung konventionell mit einer Schichtdicke von 32 µm pro Seite versehen. Eine Probe wurde abgeteilt und untersucht. **Figur 1** oben zeigt eine Aufnahme eines Teilbereichs der abgeteilten Probe im Querschliff das Substrat (1) und die Schmelztauchbeschichtungsschicht (2), welche mittels Rasterelektronenmikroskops (REM) aufgenommen worden ist. Gut zu erkennen ist die Verteilung der Zinkprimärkristalle (2.1) und Zink-Aluminium-Eutektika (2.2) innerhalb der Schicht (2). Das so schmelztauchbeschichtete Warmband wurde in einer separaten Anlage einer PVD-Applikation zusätzlich mit Magnesium, welches als Draht zugeführt, verdampft und mit einem Formiergas mit 5 Vol.-% Wasserstoff auf das durchgeführte Warmband mit einer Schichtdicke von 320 nm abgeschieden und anschließend für 10 s bei 385°C wärmbehandelt worden ist, um eine Legierungsschicht (3) bzw. einen Überzug zu erhalten, s. Figur 1 unten. Gut zu erkennen ist der Einfluss des Magnesiums, welcher über die physikalische Abscheidung und anschließende Wärmebehandlung in der Legierungsschicht (3) eingebracht wird, wobei sich innerhalb der Legierungsschicht (1) neben Zink- (3.1) und Aluminium-Zink-Phasen (3.3) auch die korrosionshemmenden Magnesium-Zink-Phasen (3.2), sowie eine vorteilhafte magnesiumreiche Oberflächenschicht (3.4) ausgebildet haben. Aufgrund der gewählten Wärmebehandlungsparameter ist ein ausgehend von der freien Oberfläche des Überzugs (3) in Richtung des Stahlsubstrats (1) abnehmender Magnesiumgehalt eingestellt worden.

Die Bestimmung einer oberflächennahen chemischen Zusammensetzung kann beispielsweise mittels Röntgenphotoelektronenspektroskopie (XPS) erfolgen, wobei die Vorgehensweise zur Bestimmung der einzelnen chemischen Zusammensetzungen aus dem Stand der Technik geläufig ist. Die Messung kann beispielsweise mit dem Gerät Phi Quantera II SXM Scanning XPS Microprobe von Physical Electronics GmbH durchgeführt werden. Die mittels der XPS gemessenen Elementkonzentrationen können Übersichtsspektren entnommen werden, die bei beispielsweise einer Durchlassenergie von 280eV im Zuge von mindestens 7 Zyklen aufgenommen werden und sich beispielsweise auf eine Messfläche von 100x100 µm² beziehen können. Die Ermittlung und Bestimmung der normierten Konzentrationen mittels ToF-SIMS wurden bereits dargelegt. Die ToF-SIMS Charakterisierung kann in einer Messfläche von 200x200 µm² oder 500x500 µm² erfolgen.

Somit ergab die Untersuchung an der freien Oberfläche des Überzugs (3) einen normierten Magnesiumanteil von 85 %, einen normierten Aluminiumanteil von 6 % und einen normierten Zinkanteil von 9 %. Der Überzug (3) wies einen Magnesiumgehalt von 11 Gew.-% auf. Die Vickershärte betrug 150 HV0,1. Es ist zu beachten, dass bei der Messung der Vickershärte größere Streuungen auftreten. Die Genauigkeit der Messung beträgt etwa ± 15 HV0,1.

Weitere Untersuchungen wurden mit der gleichen Stahlgüte und -dicke durchgeführt.

In einer zweiten Untersuchung wurde eine AZ-Schmelztauchbeschichtung konventionell mit einer Schichtdicke von 25 µm pro Seite aufgebracht. Das so schmelztauchbeschichtete Warmband wurde in einer separaten Anlage einer PVD-Applikation zusätzlich mit Magnesium und Zink (jeweils 50%), welche als Mg-Zn-Legierungsdraht zugeführt, verdampft und mit einem Formiergas mit 5 Vol.-% Wasserstoff auf das durchgeführte Warmband mit einer Schichtdicke von 400 nm abgeschieden und anschließend für 25 s bei 400°C wärmbehandelt worden ist, um eine durchlegierte Legierungsschicht zu erhalten. An der freien Oberfläche des Überzugs wurde ein normierter Magnesiumanteil mit 70 %, ein normierter Aluminiumanteil mit 6 %, ein normierter Zinkanteil mit 25 % und ein normierter Siliziumanteil mit < 1 % ermittelt. Der Überzug (3) wies einen Magnesiumgehalt von 9 Gew.-% auf. Die Vickershärte betrug 220 HV0,1. Es ist zu beachten, dass bei der Messung der Vickershärte größere Streuungen auftreten. Die Genauigkeit der Messung beträgt etwa ± 15 HV0,1.

In einer dritten Untersuchung wurde eine ZM-Schmelztauchbeschichtung konventionell (Al und Mg mit jeweils 1,5 Gew.-%) mit einer Schichtdicke von 22 µm pro Seite aufgebracht. Das so schmelztauchbeschichtete Warmband wurde einer sauren Behandlung (Dekapieren) unterzogen, um die magnesiumreiche Oxidschicht, welche sich prozessbedingt nach dem Schmelztauchbeschichten ausgebildet hatte, vollständig zu entfernen, um eine Haftung der nachfolgenden physikalisch abgeschiedenen Schicht zu gewährleisten. In einer separaten Anlage einer PVD-Applikation wurde zusätzlich mit Magnesium und Zink (jeweils 50%), welche als Mg-Zn-Legierungsdraht zugeführt, verdampft und mit einem Formiergas mit 5 Vol.-% Wasserstoff auf das durchgeführte Warmband mit einer Schichtdicke von 300 nm abgeschieden und anschließend für 20 s bei 395 °C wärmbehandelt worden ist, um eine durchlegierte Legierungsschicht zu erhalten. An der freien Oberfläche des Überzugs wurde ein normierter Magnesiumanteil mit 76 %, ein normierter Aluminiumanteil mit 4 % und ein normierter Zinkanteil mit 20 % ermittelt. Der Überzug (3) wies einen Magnesiumgehalt von 20 Gew.-% auf. Die Vickershärte betrug 180 HV0,1. Es ist zu beachten, dass bei der Messung der Vickershärte größere Streuungen auftreten. Die Genauigkeit der Messung beträgt etwa ± 15 HV0,1.

## Patentansprüche

1. Stahlblech mit einem Stahlsubstrat und einem auf dem Stahlsubstrat (1) ein- oder beidseitig angeordneten metallischen Überzug (3), welcher als Legierungsschicht ausgeführt ist und aus den folgenden Elementen besteht:
- Aluminium 0,15 bis 58 Gew.-%
- Magnesium 3 bis 25 Gew.-%
- Silizium bis 3 Gew.-%
- Rest Zink und unvermeidbare Verunreinigungen
**dadurch gekennzeichnet, dass** der Magnesiumgehalt ausgehend von der freien Oberfläche des Überzugs (3) in Richtung des Stahlsubstrats (1) abnimmt.

2. Stahlblech nach Anspruch 1, **dadurch gekennzeichnet, dass** der metallische Überzug (3), welcher als Legierungsschicht ausgeführt ist und aus den folgenden Elementen besteht:
- Aluminium 0,15 bis 1,5 Gew.-%
- Magnesium 3 bis 10 Gew.-%
- Silizium bis 3 Gew.-%
Rest Zink und unvermeidbare Verunreinigungen.

3. Stahlblech nach einem der vorhergehenden Ansprüche, wobei die freie Oberfläche des Überzugs (3) einen normierten Magnesiumanteil von mindestens 65 % aufweist, wobei die Summe der normierten Anteile von Magnesium und mindestens eines weiteren Elements aus der Gruppe (Aluminium, Zink, Silizium) 100 % beträgt, wobei mittels ToF-SIMS Rohsignale-Integrale der vorhandenen Elemente gemessen werden und der normierte Mg-Anteil aus dem Quotienten Mg-Rohsignal-Integral / Summe der vorhandenen Elemente-Rohsignal-Integrale bestimmt wird.

4. Stahlblech nach einem der vorhergehenden Ansprüche, wobei die freie Oberfläche des Überzuges eine Vickershärte von mindestens 130 HV0,1, bevorzugt mindestens 160 HV0,1 aufweist.

5. Stahlblech nach einem der vorgenannten Ansprüche, wobei der Überzug (3) eine Dicke von 20 bis 100 µm pro Seite aufweist.

6. Stahlblech nach einem der vorgenannten Ansprüche, wobei das Stahlsubstrat (1) eine Legierung enthält oder besteht aus den folgenden Elementen in Gew.-%:
| | |
|---|---|
| C: | 0,050 bis 0,250 %; |
| Si: | 0,0010 bis 0,70 %; |
| Mn: | 0,010 bis 1,70 %; |
| P: | bis 0,10 %; |
| S: | bis 0,050 %; |
| N: | bis 0,10 %; |
| Al: | 0,010 bis 0,150 %; |
optional eines oder mehrere folgender Elemente:
Cu bis 0,80 % und/oder
Cr bis 0,70 % und/oder
Nb bis 0,10 % und/oder
Ti bis 0,20 %;
Rest Eisen und erschmelzungsbedingte Verunreinigungen.

7. Verfahren zum Herstellen eines Stahlblechs mit einem metallischen Überzug (3), umfassend folgende Schritte:
- Bereitstellen eines Stahlsubstrats (1),
- ein- oder beidseitiges Schmelztauchbeschichten (2) auf Zinkbasis des Stahlsubstrats (1),
- Aufbringen einer weiteren Beschichtung auf der schmelztauchbeschichteten Seite durch physikalische Abscheidung auf Magnesiumbasis,
- Wärmebehandlung zur Ausbildung einer Legierungsschicht (3),
**dadurch gekennzeichnet, dass** der zinkbasierten Schmelze Aluminium mit einem Gehalt von mindestens 0,15 Gew.-% zulegiert wird.

8. Verfahren nach Anspruch 7, **dadurch gekennzeichnet, dass** die beim Schmelztauchbeschichten aufgebrachte zinkbasierte Schmelztauchbeschichtung aus den folgenden Elementen besteht:
- Aluminium 0,15 bis 58 Gew.-%
- Magnesium bis 8 Gew.-%
- Silizium bis 3 Gew.-%
Rest Zink und unvermeidbare Verunreinigungen.

9. Verfahren nach einem der Ansprüche 7 bis 8, **dadurch gekennzeichnet, dass** die zinkbasierte Schmelztauchbeschichtung aus den folgenden Elementen besteht:
- Aluminium 0,15 bis 1,5 Gew.-%
- Magnesium bis 8 Gew.-%
- Silizium bis 3 Gew.-%
Rest Zink und unvermeidbare Verunreinigungen.

10. Verfahren nach einem der Ansprüche 7 bis 9, **dadurch gekennzeichnet, dass** die Wärmebehandlung zwischen der Liquidustemperatur und der Solidustemperatur des Überzugs erfolgt.

11. Verfahren nach einem der Ansprüche 7 bis 9, **dadurch gekennzeichnet, dass** die Wärmebehandlung unterhalb der Solidustemperatur des Überzugs erfolgt.

12. Verfahren nach einem der Ansprüche 7 bis 11, wobei die Schritte der Schmelztauchbeschichtung und der physikalischen Abscheidung diskontinuierlich in separaten Anlagen durchgeführt werden.

13. Verfahren nach einem der Ansprüche 7 bis 11, wobei der Schritt der physikalischen Abscheidung kontinuierlich im Anschluss an die Schmelztauchbeschichtung durchgeführt wird.

14. Verfahren nach einem der Ansprüche 7 bis 13, wobei ein Dressierschritt nach der Schmelztauchbeschichtung und vor dem physikalischen Abscheiden durchgeführt wird.

15. Verfahren nach einem der Ansprüche 7 bis 13, wobei ein Dressierschritt nach dem physikalischen Abscheiden und der Wärmebehandlung durchgeführt wird.

16. Verfahren nach einem der Ansprüche 7 bis 15, wobei nach dem physikalischen Abscheiden und der Wärmebehandlung und optionalen Dressierschritt eine Konversionsschicht, Passivierung oder Beölung appliziert wird.
